# FASCICULE DE BREVET EUROPEEN

(11) **EP 0 631 701 B1**
(45) Date de publication et mention de la délivrance du brevet: **16.09.1998**
(21) Numéro de dépôt: 93920556.3
(22) Date de dépôt: 15.03.1993
(51) Int. Cl.: H03L 7/26

(54) **RESONATEUR A JET ATOMIQUE, NOTAMMENT A JET DE CESIUM**
RESONATOR FÜR ATOMSTRAHL, INSBESONDERE CÄSIUMSTRAHL
ATOMIC BEAM RESONATOR, PARTICULARLY A CESIUM BEAM RESONATOR

(30) Priorité: 16.03.1992 FR 9203103
(43) Date de publication de la demande: 04.01.1995
(73) Titulaire: TEKELEC AIRTRONIC, 93310 Sèvres (FR)
(72) Inventeur: PETIT, Pierre, Henri, François, F-91190 Gif-sur-Yvette (FR); GIORDANO, Vincent, Pierre, F-91120 Palaiseau (FR); CEREZ, Pierre, Jean, Charles, F-92160 Antony (FR); AUDOIN, Claude, Louis, Albert, F-92290 Chatenay-Malabry (FR)
(74) Mandataire: Berger, Helmut
(86) Numéro de dépôt international: FR9300257
(87) Numéro de publication internationale: WO9319531

(56) Documents cités:
- FR-A- 2 541 047
- FR-A- 2 655 807
- US-A- 4 661 782

## Description

L'invention concerne un résonateur à jet automatique de type décrit dans le préambule de la revendication principale.

Des résonateurs à jet atomique de ce type sont déjà connus. L'injection de l'énergie hyperfréquence est habituellement réalisée par un couplage magnétique au moyen d'un Té-H. Dans ce cas les deux champs d'interrogation hyperfréquences sont en phase et la réponse du résonateur présente un maximum à la fréquence de résonance.

Ces résonateurs connus présentent des inconvénients considérables, aussi bien du point de vue électrique que mécanique. Ainsi, le couplage à l'aide d'un élément guide d'onde en forme d'un Té rend le résonateur encombrant. Ce couplage utilisant un Té en guide d'onde qui doit traverser le blindage magnétique produit des perturbations importantes du champ magnétique statique, ce qui est défavorable à l'obtention d'une bonne stabilité de fréquence à long terme et d'une bonne exactitude. De plus, du fait que la réponse du résonateur présente un maximum à la fréquence de résonance, la stabilité de fréquence à court terme du résonateur est limitée par le bruit de grenaille associé au flux atomique détecté à la résonance. D'autre part, pour cette réponse du résonateur ayant un maximum à la fréquence de résonance, l'amplitude de la modulation de fréquence appliquée au signal d'interrogation doit être relativement grande, ce qui occasionne des déplacements importants de la fréquence de résonance atomique en cas par exemple d'un désaccord de la cavité.

On connaît déjà un résonateur à jet atomique par le document FR-A-2 655 807 qui permet d'obtenir une réduction des perturbations du champ magnétique, mais n'apporte aucune solution aux autres problèmes.

La présente invention a pour but de proposer un résonateur à jet atomique qui remédie à l'ensemble des inconvénients de l'état de la technique, qui viennent d'être énoncés, et permet de réduire l'encombrement, le bruit de grenaille et la grande amplitude de modulation requise.

Pour atteindre ce but, le résonateur selon l'invention comporte les caractéristiques qui sont indiquées dans la revendication 1.

D'autres caractéristiques avantageuses de l'invention font les objets de revendications dépendantes.

L'invention sera mieux comprise et d'autres buts, caractéristiques, détails et avantages de celle-ci apparaîtront plus clairement au cours de la description explicative qui va suivre faite en référence aux dessins schématiques annexés donnés uniquement à titre d'exemple illustrant un mode de réalisation de l'invention et dans lesquels :
La figure 1 est une vue en perspective d'un résonateur à jet atomique selon la présente invention, avec des arrachements partiels ;
La figure 2 est une vue en coupe axiale selon la ligne II-II de la figure 1, mais représentant seulement la zone d'interrogation du résonateur ;
La figure 3 est une vue en direction de la flèche III de la figure 2;
La figure 4 est une vue en coupe selon la ligne IV-IV de la figure 2;
La figure 5 montre une autre version de réalisation de couplage électrique pour l'injection de l'énergie d'interrogation;
La figure 6 illustre sous forme d'une courbe, la réponse du résonateur selon l'invention;

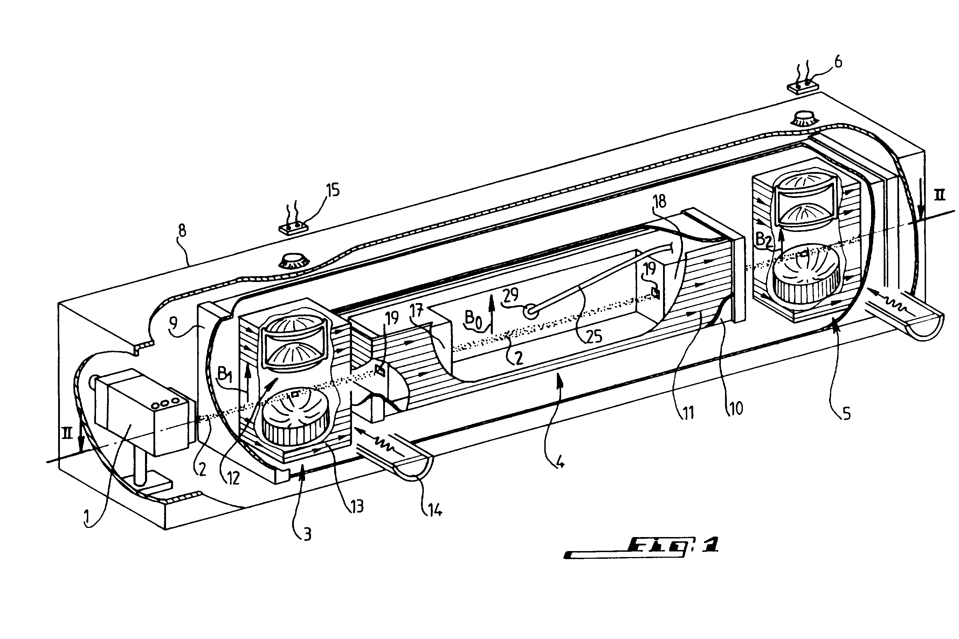

La figure 1 montre un résonateur à jet atomique, dans le cas présent à jet de césium, pour une horloge atomique comprenant un oscillateur à quartz (non représenté) qui est asservi en fréquence sur le signal de sortie du résonateur servant de signal de référence. Ce signal de référence correspond à la transition d'horloge à 9,192 MHz entre les deux sous-niveaux hyperfins de l'état fondamental de l'atome de césium.

Le résonateur dont la structure générale est connue en soi comprend essentiellement un four 1 formant la source du jet de césium 2 et, montés en série dans le trajet du jet 2, un premier sélecteur d'état 3, une zone d'interrogation 4, un deuxième sélecteur d'état 3, une zone d'interrogation 4, un deuxième sélecteur d'état 5 et un photodétecteur 6 destiné à capter les photons et à produire le signal utile de sortie du résonateur. L'ensemble qui vient d'être décrit, à l'exception du détecteur 6, est enfermé dans un boîtier de forme sensiblement parallélépipédique 8. Une première enveloppe de blindage désignée par 9 enferme les deux sélecteurs d'état 3 et 5 et la zone d'interrogation 4, ce dernier se trouvant dans une enveloppe de blindage magnétique spécifique 10. Le blindage 10 comporte une bobine 11 réalisée sous forme d'un circuit imprimé et intégré dans l'enveloppe de blindage. Cette bobine a pour fonction de produire un champ magnétique B₀ statique, faible d'environ 40 à 60 mG. Le champ doit être très homogène et uniforme.

Dans le mode de réalisation du résonateur représenté, les sélecteurs d'état sont du type à pompage optique à diode laser. Chacun des sélecteurs comprend un système optique 12 dans une bobine 13 génératrice d'un champ magnétique respectivement B₁ et B₂. La lumière laser est introduite à travers un hublot 14. Au sélecteur d'état 3 est associé un détecteur 15 qui reçoit la lumière laser à travers un hublot de détection et produit un signal utilisé pour la stabilisation du laser. Le photodétecteur 6 qui produit le signal de sortie du résonateur est associé au sélecteur d'état 5. Bien entendu, les sélecteurs pourraient aussi être du type à déflection magnétique, les zones d'intersection avec le laser étant alors remplacées par des aimants de sélection d'état.

La zone d'interrogation 4 est formée par un corps métallique comportant une cavité résonnante 16 à deux bras du type Ramsey. Ce corps présente la forme générale d'un C dont les deux bras 17 et 18 sont traversés perpendiculairement par le jet de césium 2, le jet étant orienté parallèlement à l'axe de la base du C. Pour permettre le passage du jet, les deux bras présentent des canaux appropriés indiqués en 19. Le corps 4 est réalisé sous forme d'un élément délimitant une cavité en guide d'onde courbée dans le plan E.

Un système électronique de synthèse de fréquence (non représenté) délivre à partir du signal de l'oscillateur à quartz un signal d'interrogation modulé en fréquence autour de 9,192 MHz qui est injecté dans la partie de la base du C de la cavité résonnante et occasionne dans la cavité délimitée dans chacun des deux bras 17 et 18 un champ hyperfréquence. Dans ces cavités les atomes du jet de césium interagissent avec le champ hyperfréquence respectif. La réponse du résonateur, fonction de la fréquence du signal d'interrogation, apparaît comme une courbe de résonance inscrite sur un fond continu. Ce dernier est dû aux imperfections du système de détection. Une démodulation synchrone permet d'extraire un signal d'erreur proportionnel à l'écart en fréquence entre le signal d'interrogation et la transition atomique. Ce signal d'erreur est mis à profit pour stabiliser la fréquence de l'oscillateur à quartz. On confère ainsi dans la bande passante de l'asservissement la stabilité de fréquence de la transition atomique à l'oscillateur à quartz.

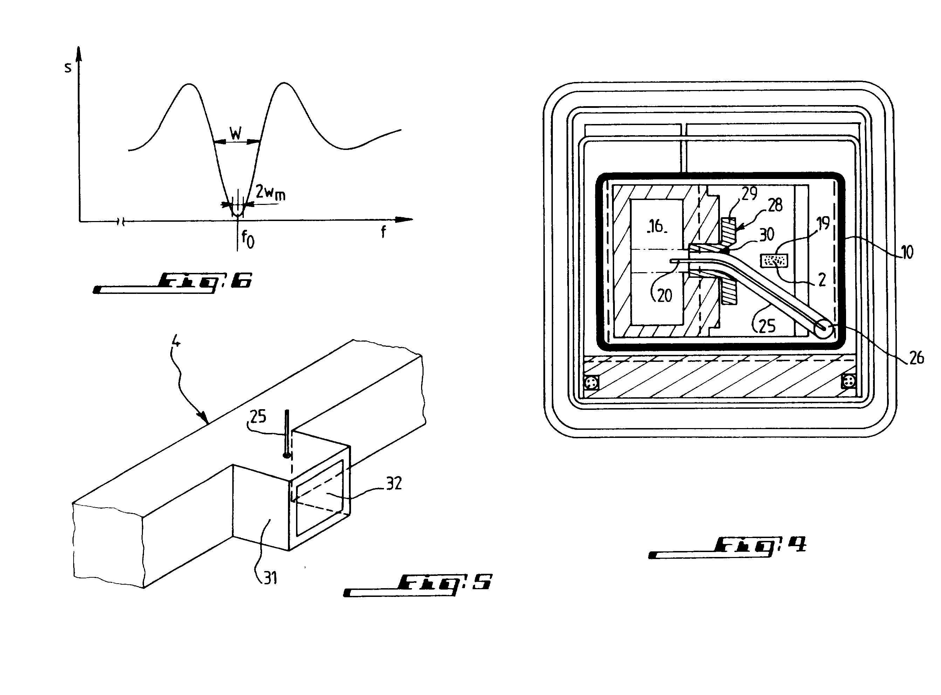

Selon la présente invention, pour assurer l'injection de cette énergie dans la cavité, on utilise un couplage électrique qui est réalisé au moyen d'une antenne 20 plongeant dans la cavité résonnante du corps guide d'onde, à travers un perçage 22 pratiqué dans la paroi intérieure de la base du C, au centre de celle-ci, de façon que l'axe de cette antenne soit confondu avec l'intersection des plans de symétrie de la cavité. L'injection de l'énergie d'interrogation par couplage électrique implique le choix d'une cavité 16 en guide d'onde standard courbée dans le plan E et résonnant suivant un nombre de modes impairs de façon que les deux champs d'interrogation hyperfréquence établis dans les deux bras de la cavité soient en opposition de phase. Le résonateur présente alors la réponse représentée à la figure 5 qui est caractérisée par un minimum à la fréquence de résonance f₀. Cette figure montre l'amplitude s du signal en fonction de la fréquence f du signal d'interrogation.

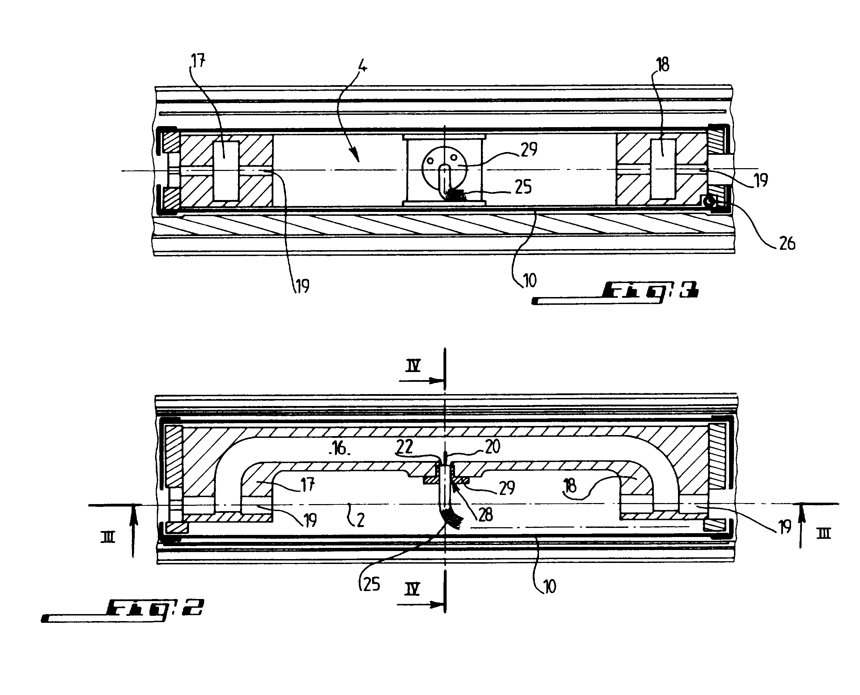

Dans l'exemple représenté, l'antenne est constituée par l'âme centrale d'un câble coaxial 25 qui est relié à une extrémité au générateur du signal d'interrogation et à son autre extrémité au corps guide d'onde 4, avantageusement à la manière représentée de façon détaillée à la figure 4. Cette antenne peut être également réalisée par une pièce conductrice prolongeant l'âme centrale d'un conducteur coaxial. Le câble coaxial traverse le blindage magnétique 10 qui protège la zone d'interrogation, par un trou de faible dimension 26. Ce trou est situé près d'une extrémité de l'enveloppe de blindage. En raison de cette position du trou et de ses faibles dimensions, les perturbations du champ magnétique statique B₀ sont minimisées. La souplesse du câble permet la fixation au guide d'onde 4 dans l'espace disponible entre les deux bras de ce corps sans que sa présence gêne le jet atomique 2. Comme le montrent notamment les figures 2 et 3, le câble peut être replié latéralement au niveau de sa fixation au guide d'onde et ensuite amené parallèlement à la paroi du blindage à proximité de celle-ci au trou de passage en étant guidé entre ce blindage et la face frontale du bras correspondant au corps guide d'onde.

Comme le montre la figure 4, la fixation du câble coaxial au guide d'onde s'effectue à l'aide d'un bouchon métallique 28 de forme cylindrique pourvu d'une collerette de fixation 29 qui fait radialement saillie vers l'extérieur et permet le montage du bouchon sur la surface extérieure de la paroi du guide d'onde à l'aide de plusieurs vis. Le câble coaxial est fixé dans le bouchon par soudure en 30. D'autres modes de fixation du câble coaxial peuvent être envisagés.

Pour assurer la rigidité du montage de l'antenne, celle-ci peut être placée dans un support en un matériau diélectrique qui fait saillie dans la cavité et pourrait venir, le cas échéant, en appui sur la face interne en regard du guide d'onde.

Sur la figure 4, un tel élément de rigidification du montage est illustré en traits interrompus et est réalisé sous forme d'un élément cylindrique en diélectrique emmanché sur l'âme du câble coaxial. L'élément pourrait être formé par un tronçon du diélectrique du câble.

La figure 5 montre un autre mode de réalisation de l'injection de l'énergie d'interrogation hyperfréquence, par couplage électrique. Dans ce cas, la base du guide d'onde en forme de C présente un embout guide d'onde 31 de forme parallélépipèdique, qui pourrait être ouvert sur sa face frontale 32 pour permettre l'injection de l'énergie. Cet embout pourrait aussi être fermé et l'injection pourrait être réalisée par une antenne, le cas échéant formée par l'âme d'un câble coaxial fixé sur la surface supérieure de l'embout, comme le montre la figure 5. L'espace interne de l'embout pourrait être utilisé pour loger des dispositifs supplémentaires éventuels.

L'injection de l'énergie d'interrogation par couplage électrique à l'aide d'un câble coaxial procure de multiples avantages considérables. Comme il ressort des figures, l'injection à l'aide d'un câble souple, notamment lorsque celui-ci est fixé sur le guide d'onde à cavité résonnante dans la zone entre les deux bras, réduit considérablement l'encombrement de l'ensemble et confère au résonateur une structure très compacte. Etant donné que le trou de passage du câble à travers le blindage présente des dimensions très faibles, juste suffisantes pour permettre le passage du câble, et en raison du fait que ce trou peut être prévu à une extrémité du blindage, le champ magnétique B₀ n'est que très faiblement perturbé par le dispositif d'injection de l'énergie dans la cavité, ce qui est favorable à l'obtention d'une bonne stabilité de fréquence à long terme et d'une bonne exactitude. Etant donné les faibles dimensions du trou de passage du câble, le champ magnétique statique B₀ peut être produit par un enroulement réalisé par un circuit imprimé à pistes conductrices parallèles intégré dans l'enveloppe de blindage, sans qu'il soit nécessaire de prévoir des mesures particulières au niveau des conducteurs pour compenser des perturbations éventuelles, ces perturbations étant minimisées dans le cas de l'invention.

Etant donné que la réponse du résonateur, illustré à la figure 6, présente un minimum à la fréquence de résonance f₀, le flux atomique détecté à la résonance est proche de zéro. Le bruit de grenaille associé à ce flux est par conséquent très faible. La stabilité de fréquence à court terme de l'horloge s'en trouve donc améliorée. D'autre part, l'amplitude de la modulation de fréquence wₘ nécessaire, appliquée au signal d'interrogation pour explorer la zone de résonance peut être relativement faible en raison du faible niveau du bruit. Cette amplitude de modulation wₘ est très faible par rapport à la largeur de raie W de la courbe de résonance. Cette diminution de l'amplitude de la modulation est favorable à la réduction de certains déplacements de fréquence tel que celui appelé "cavity pulling". Dans le cas de l'invention, en présence d'un désaccord de la cavité résonnante, le déplacement de la fréquence de résonance atomique tend à s'annuler, en raison de la faible valeur de l'amplitude wₘ.

Il est à noter que de nombreuses modifications peuvent être apportées à l'invention. En particulier, tout autre type de couplage électrique pour l'injection de l'énergie d'interrogation peut être prévu pour réaliser l'opposition de phase des champs d'interrogation dans les bras de la cavité résonnante. Il est encore à noter que l'invention est utilisable non seulement pour des résonateurs à pompage optique, comme représenté sur les figures, mais également pour des résonateurs à déflection magnétique.

## Revendications

1. Résonateur à jet atomique, notamment à jet de césium, avantageusement pour produire une fréquence de référence pour la stabilisation en fréquence d'un oscillateur à quartz, et comportant, montés en série dans la direction du jet, une source de jet atomique (2), un premier sélecteur d'état (3), une zone d'interrogation (4) comportant un guide d'onde ayant une cavité résonnante à deux bras du type Ramsey, dont les bras sont traversés transversalement par le jet atomique, un second sélecteur d'état (5), un dispositif détecteur d'atomes (15) pour produire le signal de sortie utile du résonateur et un dispositif d'injection (20, 25) dans la cavité résonnante (16) d'un signal d'interrogation produit à partir du signal dudit oscillateur, de façon à produire dans chaque bras (17, 18) de ladite cavité un champ d'interrogation hyperfréquence interagissant avec les atomes du jet atomique, la zone d'interrogation étant entourée d'un blindage magnétique (10) produisant dans l'espace interne un champ magnétique statique et homogène, caractérisé en ce que le dispositif d'injection de l'énergie hyperfréquence (20, 25) dans la cavité résonnante (16) est un dispositif de couplage qui est adapté pour imposer dans la cavité un nombre de modes impairs de façon que les deux champs d'interrogation soient en opposition de phase et que la réponse du résonateur présente un minimum à la fréquence de résonance f₀.

2. Résonateur selon la revendication 1, caractérisé en ce que le dispositif de couplage (20) est un dispositif du type à couplage électrique.

3. Résonateur selon la revendication 2, caractérisé en ce que le dispositif de couplage électrique est réalisé sous forme d'une antenne (20) plongeant dans la cavité résonnante (16) à travers un passage (22) pratiqué dans la paroi du corps guide d'onde (4) de façon que l'axe de l'antenne soit confondu avec l'intersection des plans de symétrie de la cavité.

4. Résonateur selon la revendication 3, caractérisé en ce que l'antenne (20) est constituée par l'âme centrale d'un câble coaxial (25) ou son prolongement dont une extrémité est reliée au générateur du signal d'interrogation et dont l'autre extrémité est reliée au guide d'onde (4) à cavité résonnante (16) et qui traverse l'enveloppe de blindage (10) par un trou (26) de faible diamètre correspondant avantageusement au diamètre du câble (25) et situé à un emplacement choisi pour ne pas perturber le champ magnétique statique.

5. Résonateur selon la revendication 4, caractérisé en ce que le corps (4) à cavité (16) en guide d'onde courbé dans le plan (E) et résonnant suivant un nombre de modes impairs présente la forme d'un C dont les bras (17) et (18) sont traversés par le jet atomique (2) et en ce que le câble (25) est monté sur la paroi intérieure de la base du C, qui est tournée vers les deux bras (17) et (18).

6. Résonateur selon l'une des revendications 4 ou 5, caractérisé en ce que le trou de passage (26) du câble (25) à travers le blindage (10) se trouve au niveau d'une extrémité du blindage.

7. Résonateur selon l'une des revendications précédentes, caractérisé en ce que le champ magnétique statique (B₀) de la zone d'interrogation (4) est produit par une bobine intégrée dans la paroi de l'enveloppe de blindage et réalisé avantageusement sous forme d'un circuit imprimé à pistes conductrices sensiblement parallèles.

8. Résonateur selon l'une des revendications 3 à 7, caractérisé en ce que l'extrémité de l'antenne (20) qui plonge dans la cavité résonante (16) est maintenue par un corps en un matériau diélectrique fixé à l'intérieur de la cavité.

9. Résonateur selon l'une des revendications précédentes, caractérisé en ce que le corps guide d'onde (4) comporte dans la partie centrale de la base un embout guide d'onde latéral (31) permettant l'injection de l'énergie d'interrogation.

10. Résonateur selon l'une des revendications précédentes, caractérisé en ce que l'amplitude de modulation du signal d'interrogation dans la zone autour de la fréquence de résonance f₀ présente une valeur (wₘ) qui est très faible par rapport à la largeur de raie (W) de la courbe de réponse du résonateur.

## Claims

1. Atomic beam in particular caesium beam resonator advantageously for producing a reference frequency for the frequency stabilization of a crystal-controlled oscillator and comprising, mounted in series in the direction of the beam, a source of atomic beam (2), a first state selector (3), an interrogation zone (4) comprising a wave guide having a resonant cavity with two arms of the Ramsey type, the arms of which are flown through transversely by the atomic beam, a second state selector (5), an atom detector device (15) for producing the useful output signal of the resonator and a device (20,25) for the injection into the resonant cavity(16) of an interrogation signal produced from the signal of the said oscillator so as to produce within each arm (17,18) of the said cavity a hyperfrequency interrogation field interracting with the atoms of the atomic beam, the interrogation zone being surrounded by a magnetic shielding (10) producing in the internal space, a static and homogeneous magnetic field, characterized in that the device (20,25) for the injection of the hyperfrequency energy into the resonant cavity (16) is a coupling device which is adapted to impose within the cavity a number of odd modes so that both interrogation fields be in phase opposition and that the response of the resonator exhibits a minimum at the resonance frequency f₀.

2. Resonator according to claim 1, characterized in that the coupling device (20) is a device of the electric coupling type.

3. Resonator according to claim 2, characterized in that the electric coupling device is made in the shape of an antenna (20) dipping into the resonant cavity (16) through a passageway (22) formed in the wall of the wave guide body (4) so that the axis of the antenna coincides with the intersection of the planes of symmetry of the cavity.

4. Resonator according to claim 3, characterized in that the antenna (20) is constituted by the central core of a coaxial cable (25) or its extension one end of which is connected to the interrogation signal generator and the other end of which is connected to the wave guide (4) with a resonant cavity (16) and which extends through the shielding envelope (10) through a hole (26) with a small diameter advantageously corresponding to the diameter of the cable (25) and located at a selected place in order to not disturb the static magnetic field.

5. Resonator according to claim 4, characterized in that the body (4) with a cavity (16) as a wave guide curved in the plane (E) and resonating according to a number of odd modes exhibits the shape of a C the arms (17) and (18) of which are flown through by the atomic beam (2) and in that the cable (25) is mounted onto the inner wall of the base of the C which is turned towards both arms (17) and (18).

6. Resonator according to one of the claims 4 or 5, characterized in that the hole (26) for the passage of the cable (25) through the shielding (10) is lying at the level of one end of the shielding.

7. Resonator according to one of the foregoing claims, characterized in that the static magnetic field (B₀) of the interrogation zone (4) is produced by a coil integrated into the wall of the shielding envelope and advantageously made in the shape of a printed circuit with substantially parallel conducting tracks.

8. Resonator according to one of claims 3 to 7, characterized in that that end of the antenna (20) which dips into the resonant cavity (16) is held by a body of a dielectric material fastened inside of the cavity.

9. Resonator according to one of the foregoing claims, characterized in that the wave guide body (4) comprises in the central portion of the base a side wave guide nosepiece (31) permitting the injection of the interrogation energy.

10. Resonator according to one of the foregoing claims, characterized in that the modulation amplitude of the interrogation signal in the zone about the resonance frequency f₀ exhibits a value (wₘ) which is very small with respect to the line width (W) of the response curve of the resonator.

## Patentansprüche

1. Resonator fur Atomstrahl, insbesondere für Cäsiumstrahl, vorteilhaft zur Erzeugung einer Bezugs frequenz für die Frequenzstabilisierung eines quarzgesteuerten Oszillators und mit, in der Strahlrichtung in Reihenfolge angeordnet, einer Atomstrahlquelle (2), einem ersten Zustandswähler (3), einem Abfragebereich (4) mit einem einen Resonanzhohlraum mit zwei Armen der Ramsey-Gattung aufweisenden Wellenleiter, dessen Arme durch den Atomstrahl quer durchsetzt werden, einem zweiten Zustandswähler (5), einer Atomnachweisvorrichtung (15), um das Ausgangsnutzsignal des Resonators zu erzeugen und einer Vorrichtung (20,25) zur Einspriztung, in den Resonanzhohlraum (16), eines von dem Signal des besagten Resonators ausgehend erzeugten Abfragesignals, um in jedem Arm (17,18) des besagten Hohlraumes ein mit den Atomen des Atomstrahles wechselwirkendes Ultrahochfrequenz Abfragefeld zu erzeugen, wobei der Abfragebereich durch eine in dem inneren Raum ein statisches und homogenes magnetisches Feld erzeugende magnetische Abchirmung (10) umgeben ist, dadurch gekennzeichnet, daß die Vorrichtung (20,25) zur Einspritzung der Ultrahochfrequenzenergie in den Resonanzhohlraum (16) eine Kopplungsvorrichtung ist, die angepasst ist, um in dem Hohlraum eine Anzahl von ungeraden Arten aufzuerlegen, so daß die beiden Abfragefelder gegenphasig sind und daß das Ansprechen des Resonators ein Minimum für die Frequenzresonanz f₀ aufweist.

2. Resonator nach Anspruch 1, dadurch gekennzeichnet, daß die Kopplungsvorrichtung (20) eine Vorrichtung der elektrischen Kopplungsart ist.

3. Resonator nach Anspruch 2, dadurch gekennzeichnet, daß die elektrische Kopplungsvorrichtung in der Gestalt einer durch einen in der Wand des Wellenleiterkörpers (4) gebildeten Durchbruch (22) in den Resonanzhohlraum (16) eintauchenden Antenne (20) gebildet wird, so daß die Achse der Antenne mit dem Durchschnitt der Symmetrieebenen des Hohlraumes zusammenfällt.

4. Resonator nach Anspruch 3, dadurch gekennzeichnet, daß die Antenne (20) durch die Zentralseele eines Koaxialkabels (25) oder ihren Fortsatz gebildet wird, deren eine Ende mit dem Abfragesignalgenerator verbunden ist und deren anderes Ende mit dem Wellenleiter (4) mit Resonanzhohlraum (16) verbunden ist und die die Abschirmungsumhüllung (10) durch ein Loch (26) schwachen Durchmessers durchsetzt, der vorteilhaft dem Durchmesser des Kabels (25) entspricht und daß an einer gewählten Stelle gelegen ist, um das statische magnetische Feld nicht zu stören.

5. Resonator nach Anspruch 4, dadurch gekennzeichnet, daß der Körper (4) mit als in der Ebene (E) gebogenen Wellenleiter gestaltetem Hohlraum (16), der gemäß einer Anzahl von ungeraden Arten mitschwingt, die Gestalt eines C's aufweist, dessen Arme (17) und (18) durch den Atomstrahl (2) durchsetzt werden und daß das Kabel (25) an der Innenwand der Basis des C's, die den beiden Armen (17) und (18) zuzugewandt ist, angeordnet ist.

6. Resonator nach einem der Ansprüche 4 oder 5, dadurch gekennzeichnet, daß das Durchgangsloch (26) für das Kabel (25) durch die Abschirmung (10) hindurch sich in der Höhe eines Endes der Abschirmung befindet.

7. Resonator nach einem der vorangehenden Ansprüche, dadurch gekennzeichnet, daß das statische magnetische Feld (B₀) des Abfragebereiches (4) durch eine in der Wand der Abschirmungsumhüllung eingegliederte Spule erzeugt wird und vorteilhaft in der Gestalt einer gedruckten Schaltung mit etwa parallelen leitfähigen Spuren gebildet wird.

8. Resonator nach einem der Ansprüche 3 bis 7, dadurch gekennzeichnet, daß dasjenige Ende der Antenne (20), das in den Resonanzhohlraum (16) eintaucht, durch einen innerhalb des Hohlraumes befestigten Körper aus einem dielektrischen Werkstoff gehalten wird.

9. Resonator nach einem der vorangehenden Ansprüche, dadurch gekennzeichnet, daß der Wellenleiterkörper (4) in dem Zentralteil der Basis einen die Einspritzung der Abfrageenergie gestattenden Seitenwellenleiteransatz (31) aufweist.

10. Resonator nach einem der vorangehenden Ansprüche, dadurch gekennzeichnet, daß die Amplitudenmodulation des Abfragesignals in dem Bereich um der Resonanzfrequenz f₀ herum einen Wert (wₘ), der sehr schwach in bezug auf die Linienbreite (W) der Ansprechkurve des Resonators ist, aufweist.
